# EUROPEAN PATENT SPECIFICATION

(11) **EP 2 472 718 B1**
(45) Date of publication and mention of the grant of the patent: **22.07.2015**
(21) Application number: 11290003.0
(22) Date of filing: 03.01.2011
(51) Int. Cl.: H03F 1/02

(54) **Method and system to amplify a digital signal**
Verfahren und System zur Verstärkung eines digitalen Signals
Procédé et système pour l'amplification d'un signal numérique

(43) Date of publication of application: 04.07.2012
(73) Proprietor: ALCATEL LUCENT, 92100 Boulogne-Billancourt (FR)
(72) Inventor: Dartois, Luc, 91620 Nozay (FR)
(74) Representative: Croonenbroek, Thomas Jakob

(56) References cited:
- US-A1- 2003 137 346
- US-A1- 2007 164 818
- US-A1- 2008 122 542
- US-A1- 2010 148 862

## Description

### BACKGROUND OF THE INVENTION

The present invention relates to the field of telecommunications and more specifically of amplifying a radio signal.

The spreading of wireless radio access networks, like 3G, transitional 3G, or LTE (Long Term Evolution) and 4G mobile access networks, has led to the implementation of an important pool of transmitters/receivers.

These transmitters/receivers are mostly connected to antennas, regularly set up, to cover wide areas, and base-stations covering network micro-cells. They act as a bridge, between the radio part of the network, where the information is carried by radio or microwave signals, and the digital part of the network, where the information is carried by a digital signal.

The amplification, as used herein, is the last step before the antenna during the emission of a signal. In this step the low energy digital signal is converted in a high energy radio signal that is then directed to the antenna to be transmitted. This step is sometimes referred to as power amplification.

The amplifiers used in network technology are mostly bipolar heterostructure transistors (HBT) for high power applications, where a certain amount of noise can be tolerated, and field effect transistors (FET), specially Metal Semiconductor Field Effect Transistors (MeSFET) or Metal Oxyde Semiconductor Field Effect Transistors (MOSFET).

The amplification is the most power consuming step of the emission chain. Considering the important and still rising number of antennas, even slight improvements of the consumption during said amplification lead to considerable savings in terms of energy and costs.

Another key aspect of an amplifier is its linearity. The linearity is the ability of the amplifier to deliver in output a uniformly amplified signal over the frequency range of the input signal. As opposed to band or domain filters, who are built to selectively cut off frequency domains, the amplifiers are meant to uniformly amplify a frequency band as large as possible.

The Doherty amplifier is an analog amplifier known since 1936, but reappeared recently because of its good linearity/consumption compromise with non constant envelope signals.

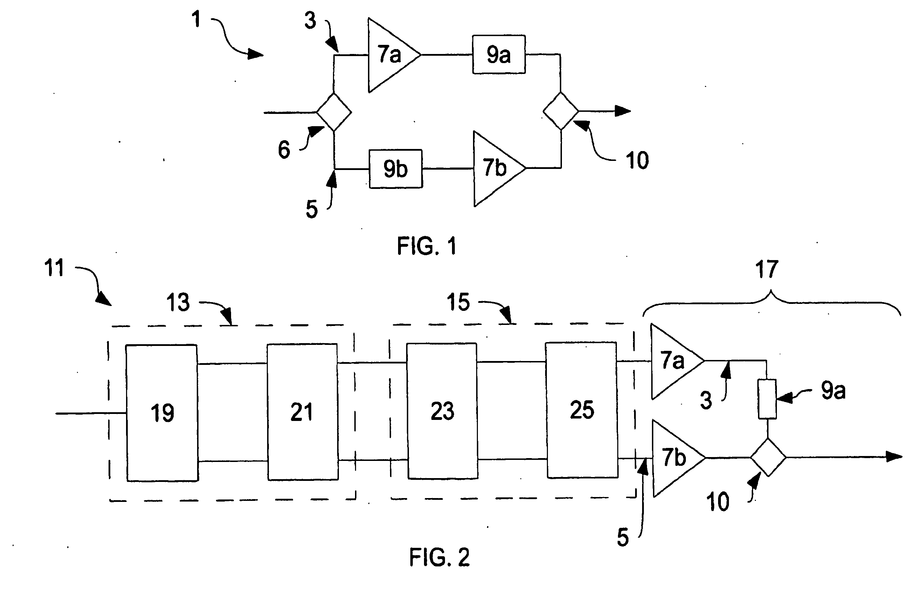

A Doherty amplifier is schematically represented on figure 1.

The Amplifier 1 has a two-branch architecture, with a main branch 3 and an auxiliary or peak branch 5. Each branch 3, 5 starts at a passive power splitter 6, and essentially features an amplifier 7a respectively 7b, originally a vacuum tube, and an impedance adapter in form of a quarter-wave transmission line 9a respectively 9b and associated resistance.

In the main branch 3, the quarter-wave transmission line 9a is placed after the amplifier 7b, in the peak branch 5, the quarter-wave transmission line 9b is placed before the amplifier 7b. The main amplifier 7a is generally a class AB amplifier, and the peak amplifier 7b a class C amplifier.

The quarter-wave transmission line 9b at the entry of the peak branch 5 ensures the uncoupling of the two branches 3, 5, the quarter-wave transmission line 9a after the main amplifier 7a ensures inphase signals at the recombination of main and peak signals.

The output of the Doherty amplifier is the combination of the signal on both branches 3, 5, combination performed by a passive combiner 10 in which the main and peak branches 3, 5 end.

The two-branch Doherty amplifier works in three different ways according to the power domain in input.

At low power, the main branch 3 conducts, while the peak branch 5 is blocked. The main amplifier 7a acts as a driven power source, the peak amplifier 7b is off.

At medium power, when the main amplifier is at saturation, the peak branch 5 starts accepting current. The main amplifier 7a is saturated, the peak amplifier 7b acts as a driven power source, and amplifies the signal exceeding the main saturation threshold.

At maximum power, both amplifiers 7a, 7b are close to saturation.

Since the input signal power for a single branch 3 or 5 is divided, lower power amplifiers 7a, 7b are required capable each of providing half the total power. Such lower power amplifiers are cheaper, and less power consuming as they need a lower drain current. Also, at low power the Doherty amplifier has a good power efficiency since only the main amplifier 7a has biasing current while the peak branch is not conducting.

To further improve the amplification process, multiple branch Doherty amplifiers can be considered.

It is also known to use a linearizer to apply a determined pre distortion to the input signal, in order to counterbalance the distortion due to the linearity defaults of the amplifier which are usually learned in an adaptive way through a measurement receiver.

Nevertheless, the saturated amplifier of the main branch in case of intermediate input power emits parasitic intermodulation due to its compression effect. Moreover, the characteristics of each branch may differ slightly. These difference lead to nonlinearities due to differences in the gain or biasing of each branch. Also, differences in the quarter-wave transmission lines lead to a different phase as a function of frequency for each branch, and have a narrow frequency domain in which they are effective to provide the real quarter wave function and branch load modulation.

### SUMMARY OF THE INVENTION

In order to overcome at least partially the aforementioned drawbacks, the invention has for object a method to amplify and convert a digital signal in a radio modulated signal for emission in a wireless radio access network, comprising the steps :
■ clipping and splitting the digital signal using at least one threshold, in a main signal and at least one peak signal, the main signal comprising the clipped digital signal and the main signal the subtracted part of the digital signal,
■ converting the main signal and the at least one peak signal in a low energy radio main signal and at least one low energy radio peak signal,
■ the low energy radio main signal is amplified in a main branch comprising a main amplifier, and the at least one low energy radio peak signal is amplified in at least one corresponding peak branch comprising a peak amplifier,
■ the output of the main amplifier and the at least one peak amplifier is combined to form the amplified output signal.

The method can also have one of the following characteristics, taken separately or in combination.

The threshold used in the clipping and splitting step corresponds to the saturation threshold of the main amplifier.

The step of clipping and splitting the digital signal comprises at least two cascading steps of clipping and splitting, wherein the main signal or the peak signal of the preceding step is used as input for the following step, to split the digital signal in one main signal and at least two peak signals.

The method further comprises a calibration step after the clipping and splitting wherein the gain of the main signal and the at least one peak signal is adapted to the saturation threshold of the main amplifier and the at least one peak amplifier.

The method further comprises a calibration step after the clipping and splitting wherein the gain and phase of the main signal and the at least one peak signal are adapted to perform a digital pre distortion compensating the linearity defaults of the main and at least one peak amplifiers.

The method further comprises a calibration step after the clipping and splitting wherein the delay between the main signal and the at least one peak signal is adapted to compensate the delay difference between the main and at least one peak branch.

The method further comprises a calibration step after the clipping and splitting wherein the phase of the at least one peak signal is shifted according to the frequency to uncouple the main signal and the at least one peak signal.

The clipping and splitting is performed using a soft-clipping algorithm.

The bias point of the main and at least one peak amplifiers is adapted to the current load level.

Another object of the invention is an amplification device to amplify and convert a digital signal in a radio modulated signal for emission in a wireless radio access network, comprising:
- a clipping and splitting unit configured to clip and split a digital signal using at least one threshold, in a main signal and at least one peak signal, the main signal comprising the clipped input digital signal and the main signal the subtracted part of the digital signal,
- a digital to radio conversion stage configured to convert the main signal and the at least one peak signal in a low energy radio main signal and at least one low energy radio peak signal,
- a main branch receiving the low energy radio main signal and comprising a main amplifier,
- at least one peak branch, receiving the peak signal and controlling one peak amplifier,
- a combiner configured to combine the output of the main amplifier and the at least one peak amplifier to form the amplified output signal.

The amplification device can also have one of the following characteristics, taken separately or in combination.

It further comprises a calibration unit configured to perform an adaptation of the main and at least one peak signals to perform a digital pre distortion compensating the linearity defaults of the main and at least one peak amplifiers.

It further comprises a calibration unit configured to perform an adaptation of the main and at least one peak signals to perform a compensation of the the delay difference between the main and at least one peak branches.

It further comprises a calibration unit configured to perform an adaptation of the main and at least one peak signals to uncouple the main signal and the at least one peak signal by shifting the phase of the peak signal according to the frequency.

The calibration unit comprises a main feedback loop and a peak feedback loop to adapt the calibration to the output of the main and at least one peak amplifiers.

It further comprises a dynamic drain bias configured to adapt the bias point of the main and at least one peak amplifiers according to the current load level.

Further characteristics of the invention will appear at the reading of the following description, describing by way of example different embodiments with reference to the accompanying drawings, in which :
- Fig. 1 represents schematically a classic, analog Doherty amplifier,
- Fig. 2 depicts a particular embodiment of a digital signal amplification device according to the invention,
- Fig. 3 depicts another embodiment of a digital amplification device according to the invention,
- Fig. 4 depicts a third embodiment of a digital amplification device according to the invention.
- Fig. 5 depicts an embodiment of a clipping and splitting unit featuring three output branches.

In all figures the same references relate to the same elements.

### DETAILED DESCRIPTION OF THE INVENTION

The invention relates to a method and related device to amplify a digital signal, and in particular, amplify and convert a digital signal in a radio modulated signal for emission in a wireless radio access network.

In 3G, transitional or LTE and 4G network equipments, the requested high up and download speed imply complex signal multiplexing. The example of a multiple carrier WCDMA (Wideband Code Division Multiple Access) signal is discussed in the present description, but the skilled person will be able to adapt the teachings to other types of signals, using for example multiple carrier bands, quadrature amplitude modulation, and frequency division modulation to encode the symbols composing the signal.

In particular, the WiMAX (Wireless MicroWave Access) signals are also suitable for the method and system here described as well as multicarrier GSM (Global System for Mobile Telecommunications) or multicarrier CDMA (Code Division Multiple Access) signals.

Figure 2 is a schematic view of one embodiment of a digital signal amplifier 11 according to the invention. It comprises three stages : a digital processing stage 13, a digital to radio conversion stage 15 and a Doherty amplification stage 17.

The digital processing stage 13 comprises a clipping and splitting unit 19 and a calibration unit 21. The clipping and splitting unit 19 receives the input signal. In a first step it performs a clipping of the input signal.

The clipping and splitting unit 19 applies a clipping algorithm to subtract at least part of the components of the signal exceeding a threshold. The clipping algorithm may be a simple hard-clipping algorithm, where signal envelope is hard limited to a given value, leading to limiting signal in amplitude but enlarging its spectrum, or a soft-clipping algorithm, where the envelope limitation is smoothed by filters to limit spectral regrowth to a given bandwidth. Soft-clipping techniques and algorithms reduce the clipping noise spreading in frequency domain but require a greater amount of processing to implement the right digital filters.

The clipping and splitting unit 19 then separates the input signal in a main digital signal sent on a main branch 3, and a digital peak signal sent on a peak branch 5. The branches 3, 5 are supposed to represent by their addition the wanted signal to be transmitted after Doherty recombination, all assuming that each branch 3, 5 amplifies properly its respective input signal.

The amplitude threshold used for the clipping is chosen according to the saturation threshold of the main amplifier 7a located further on the main branch 3. The threshold is approximately equal to the one leading to saturation in the main amplifier 7a, but slightly lower.

In the main signal the clipping and splitting unit 19 puts the clipped incoming signal, and in the peak signal, the clipping and splitting unit 19 puts the subtracted components of the input signal, this means the difference between the input and the main signals.

In order to enable a non zero wanted peak signal to be amplified by the class C peaking amplifier, the peak signal needs to be rehearsed, when not null, by an in phase signal whose amplitude corresponds just to the level necessary to initiate conduction of peak amplifier 7a.

The main and peak signals are then sent to the calibration unit 21.

The calibration unit 21 adapts at least one of the gain, the phase and the delay of the digital main and peak signals separately. The described embodiment adapts all three characteristics gain, phase and delay.

Depending on the native shorter branch (main 3 or peak 5 depending on PA analog design) it is only necessary to place the phase and delay adjust in the shorter branch 3 or 5.

In particular, the calibration unit 21 can apply as a pre distortion to the main and/or peak signal, to compensate the linearity defaults of the amplifiers 7a, 7b due to their impairments in gain, phase and delay especially at the overlap between main saturation point and peak start of conduction.

Also, the calibration unit 21 can shift the phase of the signal according to the frequency of the carrier, to compensate the narrow bandwidth in which they are linear of further implemented quarter-wave transmission lines 9a. Also, the calibration unit 21 can perform on the peak signal a quarter-wave phase shifting to retrieve the native analog Doherty principle and load modulation.

The calibration unit 21 can also delay one of the main and peak signal to compensate a delay difference in the main and peak branches 3, 5.

The processing of the digital processing stage 13 is performed by digital processing means like FPGA (Field programmable Gate Arrays), DSP or digital ASIC.

The adapted digital main and peak signals from 21 are then admitted in the digital to radio conversion stage 15.

This stage comprises one complex digital to analog converter 23 for each of main and peak signals. Each main and peak analog resulting signals are then up converted to radio signals by a converter 25 which is typically a baseband to radiofrequency converter made of local oscillators and mixers also known as modulators. To keep phase coherence between branches 3, 5 both mixers are fed with the same local oscillator.

The main and peak radio signals then proceed to the Doherty amplification stage 17.

This stage comprises a main amplifier 7a configured to amplify the main radio signal to an emission-suitable power level, and a peak amplifier 7b configured to amplify the peak radio signal to an emission-suitable power level.

The main and peak amplifiers 7a, 7b in this embodiment remain basically and respectively class AB and class C amplifiers as in the original analog Doherty scheme, and may comprise driver amplifiers, configured to pre-amplify the signal, as well as adaptation electronics to further adapt the radio signals in input of the main and peak amplifiers 7a, 7b.

An improvement that cannot be used in analog Doherty is that the driver in the peak branch 5 can be optimized in consumption while using, as for the peak amplifier 7a itself, also a class C biasing so that no peak driver consumption exists when the peak branch 5 is not excited by any signal.

On the main branch 3 is a placed, at the output of the amplifier 7a, a quarter-wave transmission line 9a. The quarter-wave transmission line 9a counterbalances the digital quarter-wave transmission performed on the peak digital signal by the adaptation unit 21 to retrieve the Doherty load modulation principle.

The main branch 3 and the peak branch 5 end in a combiner, for example a passive combiner point 10. The passive combiner point 10 adds the main and peak radio signals to form the output signal.

The digital signal amplifier 11 obtained performs an active splitting of the incoming signal. In particular, each branch 3, 5 in the Doherty amplification stage 17 can be fed with a signal clipped in order to have a maximum amplitude as close as possible to the amplifier saturation amplitude, but still underneath it. No excessive signal power is sent to the amplifiers 7a, 7b, and they are not over saturated. By avoiding over saturation of the amplifiers 7a, 7b, less analog uncontrolled intermodulation is created, and the linear behaviour of the amplifiers 7a, 7b is improved.

The digital processing stage 13 and in particular the calibration unit 21 allow to adapt gain and phase specifically for each frequency. This represents an important savings as compared to former amplification devices, where each signal at a different frequency requires specific hardware components to be calibrated.

Also, the digital processing stage 13 and its calibration unit 21 allow to reduce the quality and quantity of adaptation electronics placed upstream of the amplifiers 7a, 7b, and in particular driver amplifiers of a lower consumption class (B or C) can be used especially in peak branch 5.

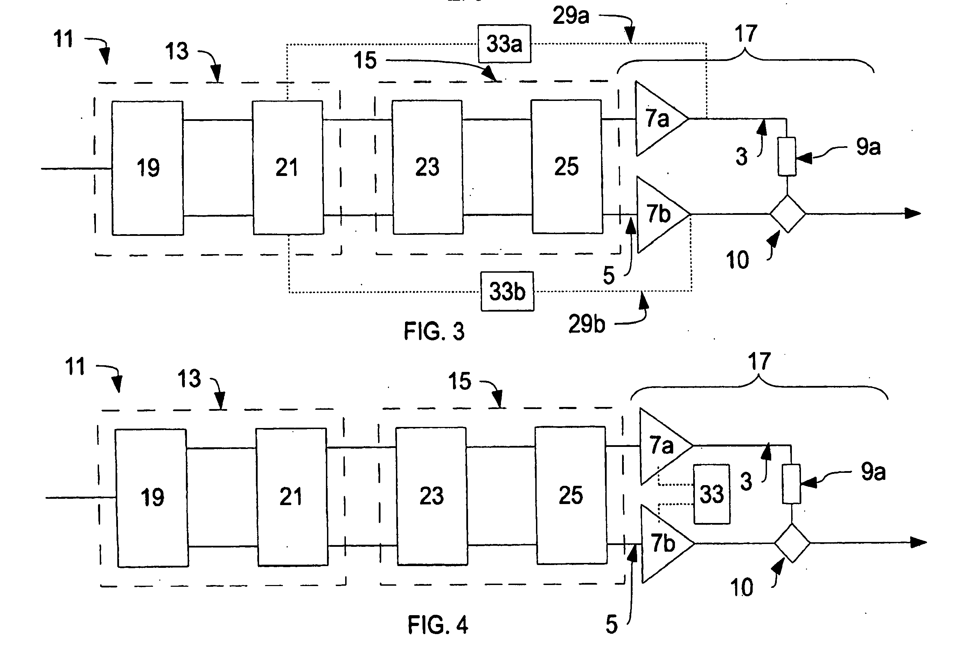

Figure 3 represents an alternative embodiment of a digital signal amplification device 11, derived from the embodiment of figure 2.

The digital signal amplification device 11 further features feedback loops 29a, 29b.

A main feedback loop 29a starts at the output of the main amplifier 7a, and goes to the calibration unit 21. A peak feedback loop 29b starts at the output of the peak amplifier 7b, and goes to the calibration unit 21.

The feedback loops 29a, 29b may also comprise radio to digital converters 31 a, 31b, one per feedback loop 29a or 29b. The radio to digital converters 31a, 31b are there to supply the calibration unit 21 directly with digital signals it can process.

With the feedback loops 29a, 29b, the calibration unit 21 can dynamically adjust its calibration to optimize the output value for each branch, main 3 and peak 5, separately.

Figure 4 represents an alternative embodiment of a digital signal amplification device 11, derived from the embodiment of figure 2.

The digital signal amplification device 11 further features a dynamic drain bias adapter 33.

The dynamic drain bias adapter 33 is configured to dynamically adapt the drain voltage or current of the amplifiers 7a, 7b according to the current traffic load in the network, so that further energy savings can be done.

All the above described embodiments are represented with a two-branch 3, 5 architecture, but a three-branch architecture and further multi-branch architectures are also achievable.

A three-branch Doherty architecture is suitable either when the signal envelope modulation has a high peak to average ratio or for stations where high efficiency is required during periods at low traffic load.

Since at low load the signal is concentrated on the lower part of the amplitude, the high amplitude peak branches of a multiple-branch Doherty amplifier can be powered down. For example during night time important energy savings can be done.

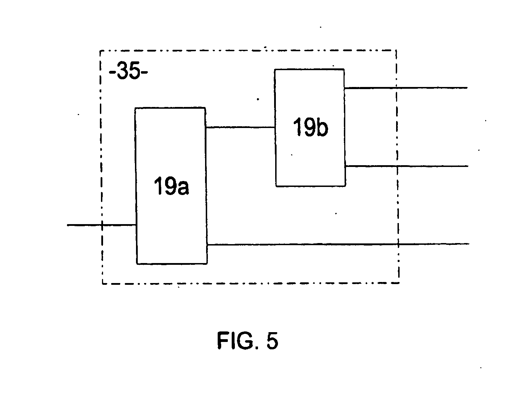

Figure 5 shows a schematic illustrating the realisation of a three-way signal clipping and splitting unit 35 to allow the realisation of three-branch amplification devices according to the invention.

In figure 5, the clipping and splitting unit 35 comprises two steps, or subunits, 19a, 19b that perform a clipping and splitting of an input signal in two signals, main and peak in a way similar to the aforementioned two-way clipping and splitting unit 19.

To obtain the three-way clipping and splitting unit 35 the two subunits are arranged so as to cascade, the main signal of the first one 19a is used as input for the second one 19b. Consequently, the output of the three-way clipping and splitting unit 35 comprises the main signal of the second subunit 19b, the peak signal of the second subunit 19b, and the peak signal of the first subunit 19a.

Of course, an alternative embodiment wherein the peak signal of the first subunit 19a is used as input for the second subunit 19b results in an equivalent three-way clipping and splitting unit 35.

By putting further subunits 19a, 19b in cascade, a multiple-way splitting and clipping unit 35 is achieved, corresponding to multiple-branch amplification devices 11, and in particular both main and peak signals of one subunit 19a, 19b can be used as input for following subunits 19a, 19b.

The embodiments described above allow an active splitting of the signal between the branches 3, 5. Also, the individual main and peak signals can be adapted in the digital processing stage 13, where all parameters are controlled. Furthermore, all the steps performed in the digital processing stage 13 can be performed by a single computer. Such computers are already present in the network architecture as servers, and only need to be configured correctly. Since some steps performed in the digital processing stage 13 replace some apparatus that would otherwise be implemented and powered, significant savings can be done.

## Claims

1. Method to amplify and convert a digital signal in a radio modulated signal for emission in a wireless radio access network, comprising the steps :
▪ clipping and splitting the digital signal using at least one threshold, in a main signal and at least one peak signal, the main signal comprising the clipped digital signal and the peak signal the subtracted part of the digital signal,
▪ converting the main signal and the at least one peak signal in a low energy radio main signal and at least one low energy radio peak signal,
▪ the low energy radio main signal is amplified in a main branch (3) comprising a main amplifier (7a), and the at least one low energy radio peak signal is amplified in at least one corresponding peak branch (3) comprising a peak amplifier (7b),
▪ the output of the main amplifier (7a) and the at least one peak
amplifier (7b) is combined to form the amplified output signal.,
and wherein the step of clipping and splitting the digital signal comprises at least two cascading steps of clipping and splitting, wherein the main signal or the peak signal of the preceding step is used as input for the following step, to split the digital signal in one main signal and at least two peak signals.

2. Method according to claim 1, wherein the threshold used in the clipping and splitting step corresponds to the saturation threshold of the main amplifier (7a).

3. Method according to claim 1 or 2, further comprising a calibration step after the clipping and splitting wherein the gain of the main signal and the at least one peak signal is adapted to the saturation threshold of the main amplifier (7a) and the at least one peak amplifier (7b).

4. Method according to any of claims 1 to 3, further comprising a calibration step after the clipping and splitting wherein the gain and phase of the main signal and the at least one peak signal are adapted to perform a digital pre distortion compensating the linearity defaults of the main and at least one peak amplifiers (7a, 7b).

5. Method according to any of claims 1 to 4, further comprising a calibration step after the clipping and splitting wherein the delay between the main signal and the at least one peak signal is adapted to compensate the delay difference between the main and at least one peak branch (3, 5).

6. Method according to any of claims 1 to 5, further comprising a calibration step after the clipping and splitting wherein the phase of the at least two peak signals is shifted according to the frequency to uncouple the main signal and the at least two peak signals.

7. Method according to any of claims 1 to 6, wherein the clipping and splitting is performed using a soft-clipping algorithm.

8. Method according to any of the precedent claims, wherein the bias point of the main and at least one peak amplifier (7a, 7b) is adapted to the current load level.

9. Amplification device (11) to amplify and convert a digital signal in a radio modulated signal for emission in a wireless radio access network, comprising :
- a clipping and splitting unit (19) comprising a plurality of clipping and splitting subunits (19a, 19b) configured to clip and split a digital signal using at least one threshold in a main signal and at least one peak signal, the main signal comprising the clipped input digital signal and the peak signal the subtracted part of the digital signal, the subunits (19a, 19b) being disposed in a cascading architecture, wherein the main signal or the peak signal of a preceding subunit is used as input for the following subunit, to split the digital signal in one main signal and at least two peak signals
- a digital to radio conversion stage (15) configured to convert the main signal and the at least two peak signals in a low energy radio main signal and at least two low energy radio peak signals,
- a main branch (3) receiving the low energy radio main signal and comprising a main amplifier (7a),
- at least two peak branches (5), receiving the peak signals and comprising one peak amplifier (7b),
- a combiner (10) configured to combine the output of the main amplifier (7a) and the at least two peak amplifiers (7b) to form the amplified output signal.

10. Amplification device according to claim 10, further comprising a calibration unit (21) configured to perform an adaptation of the main and at least two peak signals to perform a digital pre distortion compensating the linearity defaults of the main and at least one peak amplifier (7a, 7b).

11. Amplification device according to claim 10 or 11, further comprising a calibration unit (21) configured to perform an adaptation of the main and at least two peak signals to perform a compensation of the delay difference between the main and at least two peak branches (3, 5).

12. Amplification device according to any of claims 10 to 12, further comprising a calibration unit (21) configured to perform an adaptation of the main and at least two peak signals to uncouple the main signal and the at least two peak signals by shifting the phase of the peak signals according to the frequency.

13. Amplification device according to any of claims 11 to 13, wherein the calibration unit comprises a main feedback loop (29a) and a peak feedback loop (29b) to adapt the calibration to the output of the main and at least one peak amplifier (7a, 7b).

14. Amplification device according to any of claims 10 to 14, further comprising a dynamic drain bias (33) configured to adapt the bias point of the main and at least two peak amplifiers (7a, 7b) according to the current load level.

## Patentansprüche

1. Verfahren zum Verstärken und Konvertieren eines digitalen Signals in ein funkmoduliertes Signal für die Übertragung in einem drahtlosen Funkzugangsnetzwerk, die folgenden Schritte umfassend:
• Kappen und Aufspalten des digitalen Signals in ein Hauptsignal und mindestens ein Spitzenwertsignal unter Verwendung mindestens eines Grenzwertes, wobei des Hauptsignal das gekappte digitale Signal und das Spitzenwertsignal den subtrahierten Teil des digitalen Signals umfasst,
• Konvertieren des Hauptsignals und des mindestens einen Spitzenwertsignals in ein Niedrigenergie-Funk-Hauptsignal und mindestens ein Niedrigenergie-Funk-Spitzenwertsignal,
• wobei das Niedrigenergie-Funk-Hauptsignal in einem Hauptzweig (3), welcher einen Hauptverstärker (7a) umfasst, verstärkt wird und das mindestens eine Niedrigenergie-Funk-Spitzenwertsignal in mindestens einem entsprechenden Spitzenwertzweig (3), welcher einen Spitzenwertverstärker (7b) umfasst, verstärkt wird,
• die Ausgabe des Hauptverstärkers (7a) und des mindestens einen Spitzenwertverstärker (7b) kombiniert werden, um das verstärkte Ausgangssignal zu bilden,
und wobei der Schritt des Kappens und Aufspalten des digitalen Signals mindestens zwei kaskadierende Kapp- und Aufspaltschritte umfasst, wobei das Hauptsignal oder das Spitzenwertsignal des vorausgehenden Schrittes als eine Eingabe für den nächsten Schritt verwendet wird, um das digitale Signal in ein Hauptsignal und mindestens zwei Spitzenwertsignale aufzuspalten.

2. Verfahren nach Anspruch 1, wobei der im Kapp- und Aufspaltschritt verwendete Grenzwert dem Sättigungsgrenzwert des Hauptverstärkers (7a) entspricht.

3. Verfahren nach Anspruch 1 oder 2, weiterhin umfassend einen Kalibrierungsschritt im Anschluss an das Kappen und Aufspalten, wobei die Verstärkung des Hauptsignals und des mindestens einen Spitzenwertsignals an den Sättigungsgrenzwert des Hauptverstärkers (7a) und des mindestens einen Spitzenwertverstärkers (7b) angepasst ist.

4. Verfahren nach einem beliebigen der Ansprüche 1 bis 3, weiterhin umfassend einen Kalibrierungsschritt im Anschluss an das Kappen und Aufspalten, wobei die Verstärkung und die Phase des Hauptsignals und des mindestens einen Spitzenwertsignals geeignet sind, eine digitale Vorverzerrung durchzuführen, um die Linearitätsfehler des Hauptverstärkers und des mindestens einen Spitzenwertverstärkers (7a, 7b) auszugleichen.

5. Verfahren nach einem beliebigen der Ansprüche 1 bis 4, weiterhin umfassend einen Kalibrierungsschritt im Anschluss an das Kappen und Aufspalten, wobei die Verzögerung zwischen dem Hauptsignal und dem mindestens einen Spitzenwertsignal geeignet ist, die Verzögerungsdifferenz zwischen dem Hauptzweig und mindestens einem Spitzenwertzweig (3, 5) auszugleichen.

6. Verfahren nach einem beliebigen der Ansprüche 1 bis 5, weiterhin umfassend einen Kalibrierungsschritt im Anschluss an das Kappen und Aufspalten, wobei die Phase der mindestens zwei Spitzenwertsignale gemäß der Frequenz verschoben wird, um das Hauptsignal und die mindestens zwei Spitzenwertsignale zu entkoppeln.

7. Verfahren nach einem beliebigen der Ansprüche 1 bis 6, wobei das Kappen und Aufspalten unter Verwendung eines Soft-Clipping-Algorithmus erfolgt.

8. Verfahren nach einem beliebigen der vorstehenden Ansprüche, wobei der Vorspannungspunkt des Hauptverstärkers und mindestens eines Spitzenwertverstärkers (7a, 7b) an den momentanen Belastungsgrad angepasst wird.

9. Verstärkungsvorrichtung (11) zum Verstärken und Konvertieren eines digitalen Signals in ein funkmoduliertes Signal für die Übertragung in einem drahtlosen Funkzugangsnetzwerk, umfassend:
- eine Kapp- und Aufspalt-Einheit (19), umfassend eine Vielzahl von Kapp- und Aufspalt-Untereinheiten (19a, 19b) und dafür konfiguriert, ein digitales Signal unter Verwendung mindestens eines Grenzwertes in ein Hauptsignal und mindestens ein Spitzenwertsignal zu kappen und aufzuspalten, wobei des Hauptsignal das gekappte digitale Eingangssignal und das Spitzenwertsignal den subtrahierten Teil des digitalen Signals umfasst, wobei die Untereinheiten (19a, 19b) in einer Kaskadenarchitektur angeordnet sind, wobei das Hauptsignal oder das Spitzenwertsignal einer vorangehenden Untereinheit als Eingabe für die folgende Untereinheit verwendet wird, um das digitale Signal in ein Hauptsignal und mindestens zwei Spitzenwertsignale aufzuspalten,
- eine Digital-zu-Funk-Konversionsstufe (15), konfiguriert für das Konvertieren des Hauptsignals und der mindestens zwei Spitzenwertsignale in ein Niedrigenergie-Funk-Hauptsignal und mindestens zwei Niedrigenergie-Funk-Spitzenwertsignale,
- einen Hauptzweig (3), welcher das Niedrigenergie-Funk-Hauptsignal empfängt und einen Hauptverstärker (7a) umfasst,
- mindestens zwei Spitzenwertzweige (5), welche die Spitzenwertsignale empfangen und einen Spitzenwertverstärker (7b) umfassen,
- einen Kombinator (10), konfiguriert für das Kombinieren der Ausgaben des Hauptverstärkers (7a) und der mindestens zwei Spitzenwertverstärker (7b), um ein verstärktes Ausgangssignal zu bilden.

10. Verstärkungsvorrichtung nach Anspruch 9, weiterhin umfassend eine Kalibrierungseinheit (21), welche dazu ausgelegt ist, das Hauptsignal und mindestens zwei Spitzenwertsignale anzupassen, um eine digitale Vorverzerrung zum Ausgleichen der Linearitätsfehler des Hauptverstärkers und mindestens eines Spitzenwertverstärkers (7a, 7b) durchzuführen.

11. Verstärkungsvorrichtung nach Anspruch 9 oder 10, weiterhin umfassend eine Kalibrierungseinheit (21), welche dazu ausgelegt ist, das Hauptsignal und mindestens zwei Spitzenwertsignale anzupassen, um einen Ausgleich für den Verzögerungsunterschied zwischen dem Hauptzweig und mindestens zwei Spitzenwertzweigen (3, 5) durchzuführen.

12. Verstärkungsvorrichtung nach einem beliebigen der Ansprüche 10 bis 12, weiterhin umfassend eine Kalibrierungseinheit (21), welche dafür konfiguriert ist, eine Anpassung des Hauptsignals und mindestens zweier Spitzenwertsignale durchzuführen, um das Hauptsignal und die mindestens zwei Spitzenwertsignale durch Verschieben der Phase der Spitzenwertsignale gemäß der Frequenz zu entkoppeln.

13. Verstärkungsvorrichtung nach einem beliebigen der Ansprüche 11 bis 13, wobei die Kalibrierungseinheit eine Haupt-Rückkopplungsschleife (29a) und eine Spitzenwert-Rückkopplungsschleife (29b) umfasst, um die Kalibrierung an die Ausgabe des Hauptverstärkers und des mindestens einen Spitzenwertverstärkers (7a, 7b) anzupassen.

14. Verstärkungsvorrichtung nach einem beliebigen der Ansprüche 10 bis 14, weiterhin umfassend eine dynamische Drain-Vorspannung (33), konfiguriert für die Anpassung des Vorspannungspunktes des Hauptverstärkers und mindestens zweiter Spitzenwertverstärker (7a, 7b) gemäß dem momentanen Belastungsgrad.

## Revendications

1. Procédé pour amplifier et convertir un signal numérique en un signal radio modulé à émettre dans un réseau d'accès radio sans fil, comprenant les étapes suivantes
• écrêter et fractionner le signal numérique en utilisant au moins un seuil, en un signal principal et au moins un signal de crête, le signal principal comprenant le signal numérique écrêté et le signal de crête comprenant la partie soustraite du signal numérique,
• convertir le signal principal et l'au moins un signal de crête en un signal radio principal de faible énergie et au moins un signal radio de crête de faible énergie,
• le signal radio principal de faible énergie est amplifié dans une branche principale (3) comprenant un amplificateur principal (7a), et l'au moins un signal radio de crête de faible énergie est amplifié dans au moins une branche de crête correspondante (3) comprenant un amplificateur de crête (7b),
• la sortie de l'amplificateur principal (7a) et l'au moins un amplificateur de
crête (7b) sont combinés pour former le signal de sortie amplifié,
et dans lequel l'étape d'écrêtage et de fractionnement du signal numérique comprend au moins deux étapes en cascade d'écrêtage et de fractionnement, dans lequel le signal principal ou le signal de crête de l'étape précédente est utilisé comme entrée pour l'étape suivante, pour fractionner le signal numérique en un signal principal et au moins deux signaux de crête.

2. Procédé selon la revendication 1, dans lequel le seuil utilisé dans l'étape d'écrêtage et de fractionnement correspond au seuil de saturation de l'amplificateur principal (7a).

3. Procédé selon la revendication 1 ou 2, comprenant en outre une étape d'étalonnage après l'écrêtage et le fractionnement dans lequel le gain du signal principal et de l'au moins un signal de crête est adapté au seuil de saturation de l'amplificateur principal (7a) et de l'au moins un amplificateur de crête (7b).

4. Procédé selon l'une quelconque des revendications 1 à 3, comprenant en outre une étape d'étalonnage après l'écrêtage et le fractionnement dans lequel le gain et la phase du signal principal et de l'au moins un signal de crête sont adaptés pour effectuer une pré-distorsion numérique compensant les défauts de linéarité de l'amplificateur principal et de l'au moins un amplificateur de crête (7a, 7b).

5. Procédé selon l'une quelconque des revendications 1 à 4, comprenant en outre une étape d'étalonnage après l'écrêtage et le fractionnement dans lequel le retard entre le signal principal et l'au moins un signal de crête est adapté pour compenser la différence de retard entre la branche principale et au moins une branche de crête (3, 5).

6. Procédé selon l'une quelconque des revendications 1 à 5, comprenant en outre une étape d'étalonnage après l'écrêtage et le fractionnement dans lequel les au moins deux signaux de crête sont déphasés selon la fréquence pour découpler le signal principal et les au moins deux signaux de crête.

7. Procédé selon l'une quelconque des revendications 1 à 6, dans lequel l'écrêtage et le fractionnement sont effectués en utilisant un algorithme d'écrêtage doux.

8. Procédé selon l'une quelconque des revendications précédentes, dans lequel le point de polarisation de l'amplificateur principal et de l'au moins un amplificateur de crête (7a, 7b) est adapté au niveau de charge actuel.

9. Dispositif d'amplification (11) pour amplifier et convertir un signal numérique en un signal radio modulé à émettre dans un réseau d'accès radio sans fil, comprenant
- une unité d'écrêtage et de fractionnement (19) comprenant une pluralité de sous-unités d'écrêtage et de fractionnement (19a, 19b) configurées pour écrêter et fractionner un signal numérique en utilisant au moins un seuil, en un signal principal et au moins un signal de crête, le signal principal comprenant le signal numérique d'entrée écrêté et le signal de crête comprenant la partie soustraite du signal numérique, les sous-unités (19a, 19b) étant disposées dans une architecture en cascade, dans lequel le signal principal ou le signal de crête d'une sous-unité précédente est utilisé comme entrée pour la sous-unité suivante, pour fractionner le signal numérique en un signal principal et au moins deux signaux de crête,
- une étape de conversion numérique-radio (15) configurée pour convertir le signal principal et les au moins deux signaux de crête en un signal radio principal de faible énergie et au moins deux signaux radio de crête de faible énergie,
- une branche principale (3) recevant le signal radio principal de faible énergie et comprenant un amplificateur principal (7a),
- au moins deux branches de crête (5), recevant les signaux de crête et comprenant un amplificateur de crête (7b),
- un combineur (10) configuré pour combiner la sortie de l'amplificateur principal (7a) et la sortie des au moins deux amplificateurs de crête (7b) pour former le signal de sortie amplifié.

10. Dispositif d'amplification selon la revendication 9, comprenant en outre une unité d'étalonnage (21) configurée pour effectuer une adaptation du signal principal et des au moins deux signaux de crête pour effectuer une pré-distorsion numérique compensant les défauts de linéarité de l'amplificateur principal et de l'au moins un amplificateur de crête (7a, 7b).

11. Dispositif d'amplification selon la revendication 9 ou 10, comprenant en outre une unité d'étalonnage (21) configurée pour effectuer une adaptation du signal principal et des au moins deux signaux de crête pour effectuer une compensation de la différence de retard entre la branche principale et les au moins deux branches de crête (3, 5).

12. Dispositif d'amplification selon l'une quelconque des revendications 10 à 12, comprenant en outre une unité d'étalonnage (21) configurée pour effectuer une adaptation du signal principal et des au moins deux signaux de crête pour découpler le signal principal et les au moins deux signaux de crête en déphasant les signaux de crête selon la fréquence.

13. Dispositif d'amplification selon l'une quelconque des revendications 11 à 13, dans lequel l'unité d'étalonnage comprend une boucle de rétroaction principale (29a) et une boucle de rétroaction de crête (29b) pour adapter l'étalonnage à la sortie de l'amplificateur principal et de l'au moins un amplificateur de crête (7a, 7b).

14. Dispositif d'amplification selon l'une quelconque des revendications 10 à 14, comprenant en outre une polarisation dynamique de drain (33) configurée pour adapter le point de polarisation de l'amplificateur principal et des au moins deux amplificateurs de crête (7a, 7b) conformément au niveau de charge actuel.
